# EUROPEAN PATENT SPECIFICATION

(11) **EP 0 727 816 B1**
(45) Date of publication and mention of the grant of the patent: **26.05.2004**
(21) Application number: 96102164.9
(22) Date of filing: 14.02.1996
(51) Int. Cl.: H01L 21/306, H01L 21/00, H01L 21/3105

(54) **Method for removing particulate contaminants from a semiconductor wafer surface**
Verfahren zum Entfernen partikulärer Verunreinigungen von der Oberfläche einer Halbleiterscheibe
Procédé pour éliminer des contaminants particulaires de la surface d'une pastille semi-conductrice

(30) Priority: 15.02.1995 US 389833; 15.02.1995 US 389534
(43) Date of publication of application: 21.08.1996
(60) Divisional application: 02012492.1
(73) Proprietor: TEXAS INSTRUMENTS INCORPORATED, Dallas Texas 75265 (US)
(72) Inventor: Jain, Manoj Kumar, Plano, TX 75075 (US)
(74) Representative: Degwert, Hartmut, Dipl.-Phys.

(56) References cited:
- EP-A- 0 362 516
- EP-A- 0 537 627
- PATENT ABSTRACTS OF JAPAN vol. 008, no. 231 (E-274), 24 October 1984 & JP 59 112625 A (MITSUBISHI DENKI KK), 29 June 1984,

## Description

### FIELD OF THE INVENTION

This invention relates generally to semiconductor processing and more specifically to the removal of particulate contaminants from semiconductor devices during fabrication.

### BACKGROUND OF THE INVENTION

Semiconductor devices are built in manufacturing environments known in the art as clean rooms, which are specifically designed for the filtering and elimination of particulate contaminants. Particle control is vital to the success of semiconductor manufacturing and directly affects device yield, as a single "killer" particle adhering to a device surface may ruin an entire microelectronic circuit. Such "killer" particles need not be large, but are generally of a size at least half the width of conductor wirings and other circuit features. As such, a 0.2 µm particle adhering to a circuit with 0.8 µm features may rarely cause a malfunction, while the same particle adhering to a circuit with 0.35 µm features is much more likely to "kill" the circuit.

Despite the clean manufacturing environment, cleanup steps must generally be performed throughout the semiconductor manufacturing operation to remove particles from the wafers, or slices, upon which the circuits are fabricated. Cleanup steps are particularly important before critical processes such as lithography and after inherently dirty processes such as chemical-mechanical polishing (CMP). For instance, CMP machines typically used for planarizing or smoothing a semiconductor wafer surface employ a polish slurry containing generally submicron sized abrasive particles of a material such as silica or alumina. Hundreds to thousands of these particles, along with particles removed from a wafer itself during polishing, typically may be found on a polished wafer surface. These particles must be removed in a cleanup step or they may drastically affect device yield.

Many methods of cleanup are common to semiconductor processing, including acid rinses, rinses with deionized (DI) water or surfactant solutions, and ultrasonic, brush, or mechanical buffing cleaning using such rinses and solutions, and combinations of these. For instance, U.S. Patent 5,320,706, issued June 14, 1994 to Blackwell, discloses a method for removing polish slurry particles from a semiconductor wafer by polishing the wafer with a polishing pad while a mixture of DI water and a surfactant is applied to the wafer and the pad. This method is apparently capable of reducing the number of residual particles on a 1.27 mm (5") wafer to about 100 of 0.5 µm size and larger. Unfortunately, particle count varies roughly exponentially with particle size; that is, if 100 0.5 µm particles remain on a wafer after cleaning, it is likely that a thousand or more 0.2 µm particles remain also, each of which is capable of killing a 0.35 µm feature size circuit. Much more effective cleaning methods are required as circuit feature sizes continue to shrink, if acceptable yields are to be maintained.

### SUMMARY OF THE INVENTION

The present invention provides a method for removing particulate contaminants from a semiconductor wafer surface. This is apparently the first invention which can repeatedly reduce the number of 0.2 µm-and-larger particles on the surface of 152.4 mm (6") diameter wafers to about 10 or less, for wafers which initially contain up to many thousands of such particles. Thus one advantage of the present invention is a heretofore unknown level of particle removal effectiveness, both in level of particle removal and wafer-to-wafer repeatability.

Another advantage of the present invention is a simplification of the cleanup process, since the present invention may obviate the need for large, expensive cleaning equipment, serialized cleaning processes, and long cleaning times. Still another advantage of the present invention in at least one embodiment is the elimination of hazardous chemicals from the cleanup process while still providing an effective cleaning.

It has now been discovered that, for example, a small cleaning pad operating at high rpm may surprisingly remove submicron contaminants from a semiconductor wafer much more effectively than other known methods of particle removal. Although not well understood, it has now been observed, e.g., that buffing a 152.4 mm (6") wafer with a 114.3 mm (4.5") pad operating at roughly 200 rpm and above, concurrent with wafer rinsing using a rinse liquid such as DI water, was able to remove particles far more effectively than the same pad with the same rinse at lower rpm, even if the lower rpm was combined with higher pad pressures or much longer cleaning times. It is believed that the unexpected success of this invention may be due to an increase in centrifugal force supplied by the high cleaning pad rotational velocity, beyond some critical level required to remove particles of a given size.

Furthermore, it is believed that the success of a preferred embodiment of this invention may also be due to the high rpm and the particular cleaning configuration, which does not clean the whole wafer simultaneously but instead uses a pad which only partially overlaps the wafer during cleaning.

It is not known to what extent the spinning pad physically contacts the wafer during cleaning, and to what extent contact between the pad and wafer is provided by a layer of rinse fluid between them. As used herein, contact or contacting comprehends any combination of physical and fluid layer-induced contact.

In one aspect of the invention, a method is provided for removing particulate contaminants from a semiconductor wafer surface comprising the steps of contacting the wafer surface with a cleaning pad, supplying a rinse fluid to the wafer surface and/or the cleaning pad, and rotating the cleaning pad at a rotational velocity sufficient to provide a centripetal acceleration on at least one portion of the pad contacting the wafer of at least 24.4 m/sec² (80 ft/sec²). It is believed that the most effective cleaning occurs during a period in which the contacting, supplying, and rotating steps are occurring simultaneously, although for instance supplying the rinse fluid may begin before wafer-pad contact or extend after wafer-pad contact has ceased (i.e. the steps should be overlapping).

The method may further comprise rotating the wafer, e.g. in a wafer holder during the contacting step. The contacting step may comprise holding the wafer and cleaning pad together with a pressure greater than 6.8 kPa (1 lb/in²). Although some benefit has been observed for longer contact times, a preferred duration for the contact step is less that 20 seconds. The rinse fluid may comprise, e.g., deionized water. Cleaning may purposely be combined with CMP as a means for cleaning wafers, by chemical-mechanical polishing to remove a contaminated top surface from a wafer and cleaning by a high speed buffing process as described above.

In some embodiments, a centripetal acceleration under the specified conditions of greater than 60.96 m/sec² (200 ft/sec²) is provided. A preferred embodiment is also capable of providing a tangential velocity under the specified conditions of greater than 2.1 m/sec (7 ft/sec).

### BRIEF DESCRIPTION OF THE DRAWINGS

The present invention, including various features and advantages thereof, may be best understood by reference to the following drawing, wherein:
Figure 1 illustrates typical particle counts observed after wafer cleaning by five different methods;
Figure 2 shows a side view of a cleaning apparatus useful in the present invention;
Figure 3 shows a bottom view further illustrating the arrangement of cleaning pad, wafer, and rinse fluid supply system in the apparatus of Figure 2;
Figure 4 contains a graph of particle count vs. rpm for tests conducted with the apparatus of Figure 2;
Figure 5 contains a graph of particle count vs. pad edge centripetal acceleration for the same tests;
Figures 6-8 illustrate some other cleaning configurations which may be useful in the practice of the present invention; and Figure 9 compares particle counts for a series of wafers, after removal from an oxidation furnace and after CMP and cleaning according to the present invention.

### DETAILED DESCRIPTION OF THE PREFERRED EMBODIMENTS

The present invention, as described herein, comprises a method and apparatus for the removal of particulate contaminants from a semiconductor wafer. The present invention is described in relationship to a CMP cleanup, with the realization that the invention may be useful before or after other semiconductor operations. State-of-the-art particle counters currently cannot reliably detect particles smaller than 0.15 to 0.2 µm, therefore all particle counts discussed herein refer to particles 0.2 µm and larger. As a need for the removal of even smaller particles emerges, along with instruments for detecting such particles, it is expected that the invention described herein can be modified (e.g. by changing pad centripetal acceleration and or pad velocity) to remove such particles.

CMP of a semiconductor wafer generally leaves a slurry residue on the polished wafer surface, this residue typically comprising slurry liquid and thousands of particles. If the slurry liquid (or any replacement liquid) is allowed to evaporate from the wafer surface, the attached particles typically become much harder to remove; therefore, it is preferable that the wafer remain immersed in a suitable liquid or in a substantially saturated atmosphere until particle removal is complete, at which time the wafer may be dried, e.g. by spinning. It is also now believed that cleaning immediately after chemical-mechanical polishing may be beneficial in particle removal. Cleanup results for the processes mentioned herein include a final step of a two-sided wafer scrub and spin dry. This step may be performed on a scrubber machine such as offered commercially by Ontrek, which uses cylindrical scrub brushes and a DI water rinse to clean both sides of a polished wafer.

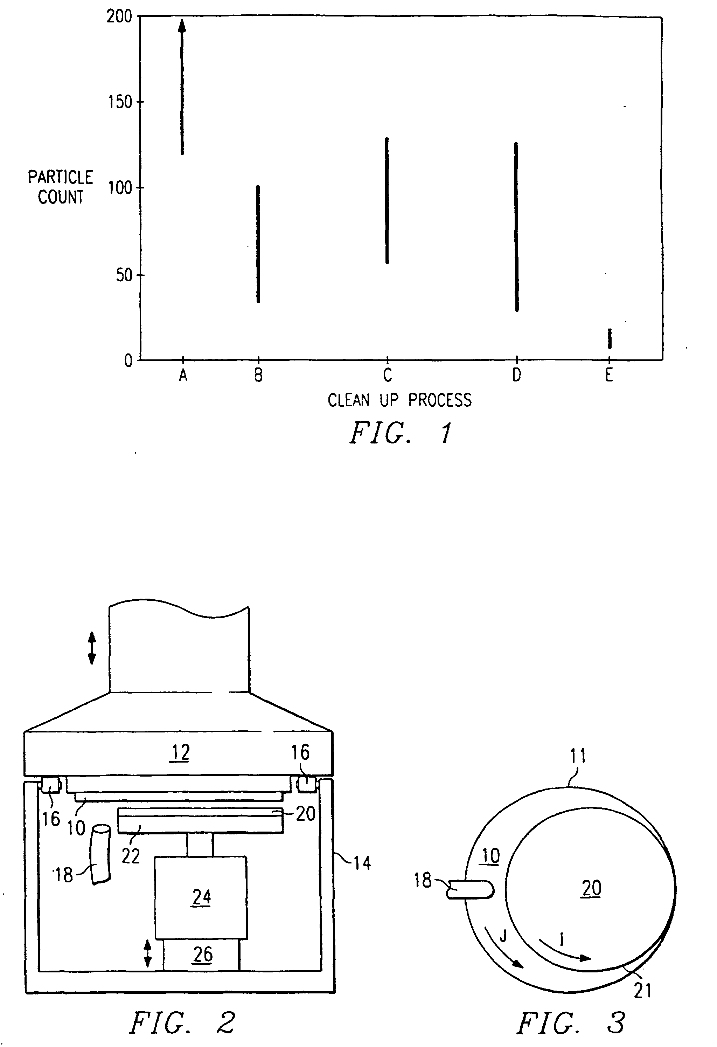

Figure 1 illustrates typical ranges of residual particles remaining on a 152.4 mm (6") wafer after several cleanup processes (each followed by Ontrek scrubbing). Process A is a DI water rinse of the wafer surface, typically comprising a stream of rinse fluid directed at the surface of a spinning wafer for about 30 seconds. This process has a high variability and typically leaves hundreds of particles on the wafer. Process B is a buffing step performed on a large, relatively slow-turning (i.e. below 80 rpm) pad and platen. Typically a rinse fluid such as DI water or a surfactant is supplied to the pad during buffing while the pad is rotated at 30-50 rpm and the wafer, is rotated at a somewhat faster rpm. Buffing pressures of 20.7-41.4 kPa (3-6 psi) are typically used for 2-3 minutes, with resulting particle counts typically in the 35 to 100 range.

Process C is a buffing step performed on a small, relatively slow-turning pad and platen, such as found on the cleanup station of a commercially-available Strasbaugh 6DS-SP polishing machine. This process uses a wafer rotation rate of about 15 rpm in conjunction with a pad rotation rate of 75 rpm or less and a supply of a rinse liquid to the wafer surface. The pad is 114.3 mm (4.5") in diameter, and cleaning pad pressures of about 6.9 kPa (1 psi) are typically used for 2-4 minutes, with resulting particle counts typically observed from about 60 to the low hundreds.

Process D is an ultrasonic cleanup, such as may be performed with a Megasonic ultrasonic cleaning tank sold commercially by Verteq. This process typically uses one or more ultrasonic clean-and-rinse steps to lift particles from a wafer surface, and is currently a cleaning method preferred in the semiconductor industry.

Process E represents cleaning typical of the present invention. It can be appreciated from Figure 1 that the present invention generally improves on cleaning as performed by other methods, and may be used to remove virtually all removable particles from a semiconductor wafer surface.

An embodiment of the present invention is illustrated in Figures 2 and 3, wherein two major pieces of the apparatus are shown, a wafer holder 12 and a cleaning station 14. This apparatus represents a standard cleanup station as supplied on a Strasbaugh 6DS-SP polisher, with modifications according to the present invention. In this polisher, wafer holder 12 uses vacuum to hold wafer 10 during polishing and cleaning operations, and is capable of rotating wafer 10 as shown in Figure 3. Cleaning station 14 comprises rollers 16 attached to station 14 such that holder 12 rests on and rotates on rollers 16 during cleaning. Station 14 further comprises a rinse fluid supply system 18, which during operation directs a stream, e.g. of DI water, and possibly containing other chemicals, towards the polished surface of wafer 10. A cleaning pad 20 is mounted to pad platen 22, which is substantially parallel to the polished surface of wafer 10. Pad 20 preferably comprises a two-pad stack, with a resilient underpad such as a Suba-4 and an upper pad typically of a polymeric composition such as a Polytex Supreme, both manufactured by Rodel. A pad stack which completely covers, or extends slightly beyond platen 22 is preferred. Pad platen 22 is mounted to drive mechanism 24, which must be capable of rotating the pad under pressure at relatively high rpm, as described herein. Finally, engagement mechanism 26 is fixed to drive mechanism 24 so as to control vertical motion of platen 22, thereby allowing for engagement and disengagement of pad 20 and wafer 10, as well as allowing control of pad contact pressure. Typically, some clearance exists between the disengaged pad and the wafer when holder 12 is resting on rollers 16.

Referring now to Figure 3, the vertical alignment of some important components, as seen from below, is shown. In particular, a 152.4 mm (6") wafer 10 and a 114.3 mm (4.5") cleaning pad 20 are shown in one preferred arrangement, with the full pad in contact with the wafer and pad edge 21 nearly aligned with wafer edge 11 (at the 3 o'clock position in this figure). Directions of rotation are shown by arrows I and J, with both wafer and pad rotating counterclockwise in this embodiment. It can also be appreciated from the positioning of 18 that during operation rinse fluid will be directed at the polished surface of 10, primarily in the region not covered by 20.

Cleaning station 14, as supplied from the manufacturer, was not intended for use in a high performance particle removal system, but rather as a bulk slurry removal system. Originally, station 14 was fitted with a drive mechanism 24 consisting of a small air motor capable of less than 75 rpm under 6.9 kPa (1 psi) pad pressure. This was replaced with a variable-speed electric motor which was capable of 600 rpm under 34.5 kPa (5 psi) pad pressure in an embodiment of the present invention.

With the variable speed electric motor in place, experiments were performed with various combinations of pad rpm, pad pressure, buffing time, and rinse solution. These experiments consisted generally of about a 10 second wafer pre-rinse, followed by buffing for a predetermined period of time, followed by a 10 second wafer post-rinse, all performed while rotating the wafer at 15 rpm. After wafers were spun dry, particle measurements were conducted using a Tencor Instruments Surfscan 6400 surface scanner. Pad pressure was varied from about 6.9 kPa (1 psi) to 27.6 kPa (4 psi) (for a small pad, it was found that larger pressures may tend to break the wafer). Pad contact times were varied from 15 seconds up to 280 seconds in some cases. Pad rpm was selected in each experiment to be one of 60, 75, 90, 180, 240, 400, or 600 rpm. Most experiments were performed with DI water as the rinse fluid, although tests were also performed with NH₄OH in a DI water solution.

It was found that increasing pad contact pressure resulted generally in decreased wafer-to-wafer particle variances for a given pad rpm, but appeared to show little, if any, decrease in mean particle count. It was also found'that increasing pad contact time resulted generally in decreased wafer-to-wafer particle variances for a given pad rpm, but appeared to show little, if any, decrease in mean particle count. Particularly in the rpm range preferred in the present invention, pad contact times longer than 15 seconds in duration appeared to have negligible effect on after-buffing mean particle count. Improved cleaning was observed for DI water rinse liquid as compared to an NH₄OH in DI water rinse liquid, for buffing at 75 rpm.

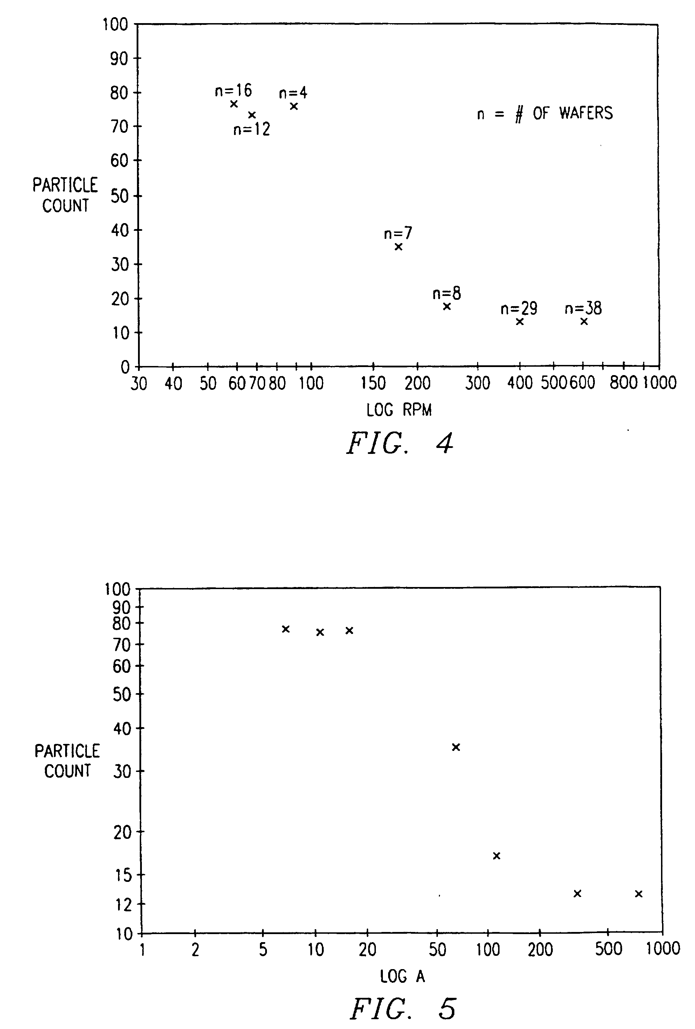

However, as illustrated in Figure 4, extremely surprising results were observed in general for high pad rotational velocity. Figure 4 shows average particles per wafer as a function of pad speed, with n representing the number of wafers included in the average. At less than 100 rpm, best average particle counts were in the 70's, but as pad speed was increased above 200 rpm, a dramatic decrease in particle count was observed, with some 4 to 6 wafer lots achieving average particle counts as low as 10 particles/wafer. These results are particularly surprising when compared to a system which employs buffing on a large pad at 30-80 rpm. A large pad turning at 80 rpm may reach linear pad velocities at the point of wafer/pad contact comparable to the linear pad velocities achieved with the 114.3 mm (4.5") pad at 200 rpm, and yet such a large pad system is not known to produce particle counts as low as those achieved by the present invention.

Although not well understood, it is believed that a major factor in the improved cleaning observed in the present invention may be related to centrifugal forces resulting from pad rotation. Large table-type pads are typically not capable of spinning at rpms which generate the centrifugal force achievable with a small pad at high rpm. Centrifugal forces vary as the square of rpm but only linearly with pad radius, making a small pad/higher rpm combination attractive if a centrifugal cleaning mechanism is actually at work in the present invention.

Since centrifugal force calculations require accelerating a known mass, an equivalent term used herein to define the present invention is centripetal acceleration for a fixed point on the pad itself, with the realization that this acceleration varies radially with distance from the center of pad rotation. Figure 5 shows average particles/wafer versus centripetal acceleration, in 0.3 m/sec² (ft/sec²), for a point on the edge of a 114.3 mm (4.5") pad. From Figure 5, it appears that for a 114.3 mm (4.5") pad and a 25° C DI water rinse fluid supply, pad edge centripetal accelerations of 24.4 m/sec² (80 ft/sec²) and greater produce consistently low particle counts, with the most preferred embodiments requiring over 60.96 m/sec² (200 ft/sec²) accelerations. An especially preferred embodiment for 152.4 mm (6") wafers uses a 114.3 mm (4.5") diameter Suba-4/Polytex Supreme pad stack as described above, a 15 second pad contact time at approximately 17.2 kPa (2.5 psi) pad pressure, a wafer rotational velocity of 5-20 rpm, a pad rotational velocity of 600 rpm (pad edge centripetal acceleration of 225.6 m/sec² (740 ft/sec²)), and a 25° C DI water rinse fluid supply directed at the exposed wafer surface for a time period extending 10 seconds before pad contact and 10 seconds after pad disengagement.

It is further believed that a factor in the improved cleaning observed in the present invention may be related to the particular cleaning arrangement, which wets the wafer directly and directs the wafer under the edge of a spinning pad. In contrast, large table-type pads typically cover the entire wafer surface while cleaning, and supply rinse fluid to the pad only.

Although configuration is believed to play a part in the present invention, an important relationship has been found to exist between pad rpm and cleaning effectiveness for a 114.3 mm (4.5") pad. Since pad speed as viewed by the wafer is a function of radial distance from the center of the pad, pads of different radii should require correspondingly different rpm for similar cleaning. A pad of a given radius, spun at a particular rpm, may be characterized by a tangential velocity at the pad edge, believed to be more particularly related than pad rpm to cleaning effectiveness. An especially preferred embodiment for 152.4 mm (6") wafers uses a 114.3 mm (4.5") diameter Suba-4/Polytex Supreme pad stack as described above, a 15 second pad contact time at approximately 17.2 kPa (2.5 psi) pad pressure, a wafer rotational velocity of 5-20 rpm, a pad rotational velocity of 600 rpm (pad edge tangential velocity of 3.7 m/sec (12 ft/sec)), and a 25° C DI water rinse fluid supply directed at the exposed wafer surface for a time period extending 10 seconds before pad contact and 10 seconds after pad disengagement. Generally, increased pad contact time and/or pressure produced somewhat better results. Results for 600 rpm tests are summarized in Table 1.

**Table 1**

| Pad Contact Pressure, kPa (psi) | Pad Contact Time, seconds | Number of Wafers | Mean Particle Count | Particle Count s |
|---|---|---|---|---|
| 17.2 (2.5) | 15 | 24 | 14.3 | 7.7 |
| 17.2 (2.5) | 40 | 6 | 10.7 | 8.0 |
| 13.8 (2.0) | 60 | 4 | 11.3 | 3.3 |
| 26.9 (3.9) | 60-120 | 4 | 12.5 | 0.8 |

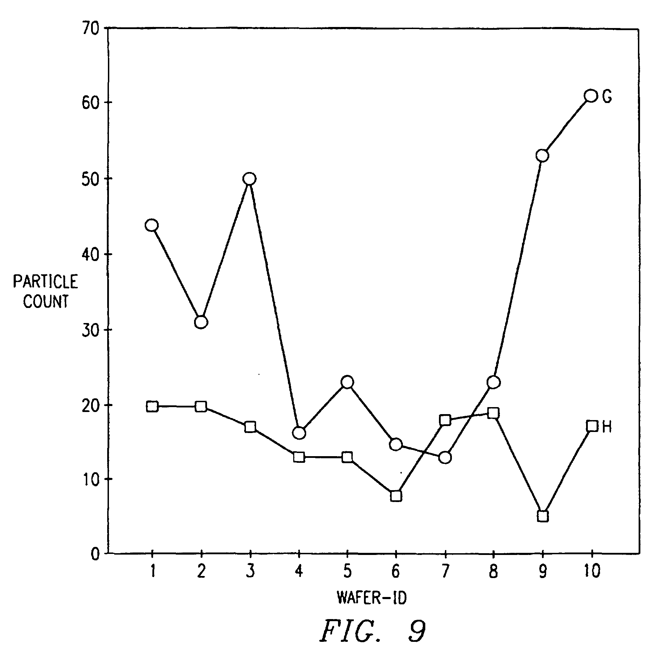

Another advantage of the invention is wafer-to-wafer repeatability. Many systems suffer in performance after the first few wafers are cleaned. Results of a repeatability test for the current invention are shown in Figure 9, wherein a lot of 10 152.4 mm (6") wafers were processed serially through a cleaning station built and operated according to the present invention. A 600 nm (6000 Å) thermal oxide was grown on the 10 wafers in a furnace, and particles were counted after removal from the furnace. Line G shows measured particles after oxide growth, which is typically considered a clean process, for the 10 wafers to have a mean of 33 particles and a standard deviation of 18 particles.

The wafers were subsequently polished in a CMP machine to remove 170 nm (1700 Å) of thermal oxide, and cleaned with a 15 second, 17.2 kPa (2.5 psi), 600 rpm cleanup in DI water according to the present invention, with 10 second pre and post wafer rinses. Particle counts for wafers 1 through 10, after CMP and cleanup, are represented by line H, with a mean of 15 particles and a standard deviation of 5 particles. Good cleaning was maintained from the first wafer to the last wafer. Surprisingly, 9 of 10 wafers were cleaner after CMP and cleanup according to the present invention than after thermal oxide growth, suggesting a combination of CMP and cleanup may both improve planarity and cleanliness for wafers after processes considered "clean" such as oxide growth or chemical vapor deposition.

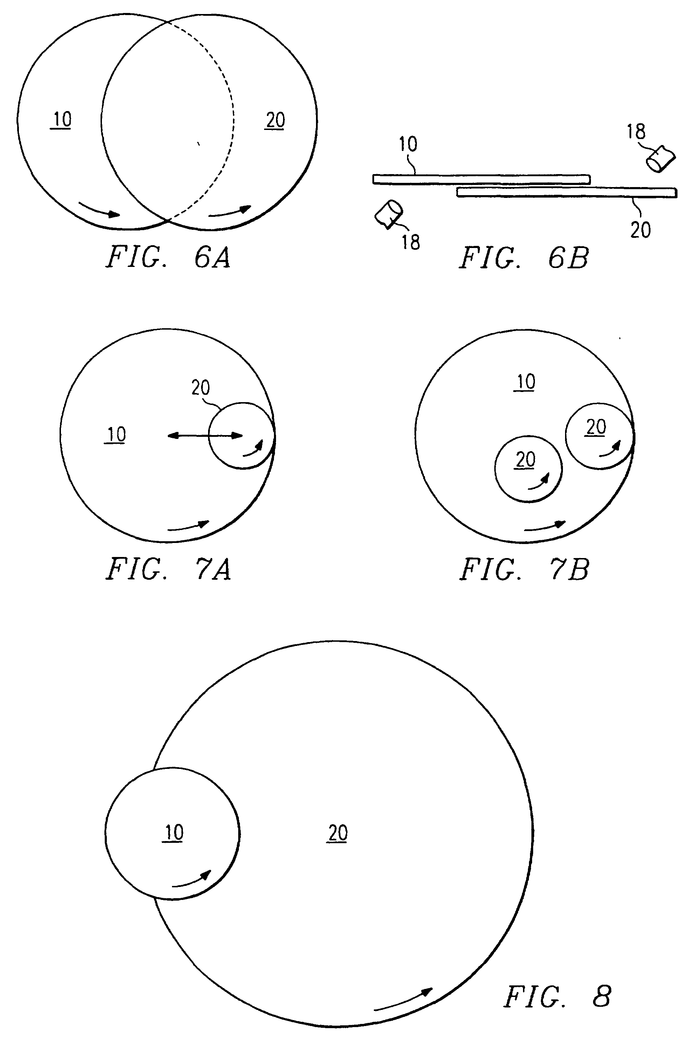

Using the teachings of the present invention, other particle removal systems may be constructed. For example, Figure 6 shows a system wherein a pad 20, comparable in diameter to wafer 10, may be partially overlapped with wafer 10 and both spun during cleaning. As shown in Figure 7, such a system may allow the rinse fluid supply system 18 to simultaneously rinse both 10 and 20. Theoretically, pad rotational velocity for such a system may be decreased slightly from that desired for a smaller-than-wafer pad system, for similar performance.

Figure 7A shows a system with a pad 20 having a diameter less than half the diameter of wafer 10. In such a system, pad 20 and/or wafer 10 could be maneuvered to provide cleaning over the entire wafer surface. As shown, pad 20 could be moved laterally across a rotating wafer 10, for example, to achieve this result. This may be a very small and efficient system, as a 40.64 mm (1.6") pad rotating at 1000 rpm has a pad edge centripetal acceleration equivalent to that of a 114.3 mm (4.5") pad at 600 rpm. Alternately, as shown if Figure 7B, multiple small pads with overlapping coverage could be used in an embodiment.

Figure 8 shows a system with a pad 20 having a diameter more than twice that of wafer 10. Such a system could use multiple wafer holders to simultaneously clean two or more wafers. However, at 228.6 mm (9") from the pad edge to achieve the pad edge centripetal acceleration, e.g., of a 114.3 mm (4.5") pad at 600 rpm, a table-type pad platen would have to spin at 300 rpm, and would require significant amounts of rinse fluid. Existing table-type platens are generally not designed to operate under these load conditions.

Furthermore, to achieve the pad edge tangential velocity, e.g., of a 114.3 mm (4.5") pad at 600 rpm, a table-type pad platen would have to spin at 150 rpm, and would probably require significant amounts of rinse fluid be supplied to the pad as well as the wafer.

Other modifications to these embodiments will be apparent to those skilled in the art upon reading this description. For example, the pad could be positioned over the wafer surface, instead of under, or the wafer could be buffed in some arrangement other than horizontal. Pad and wafer could also counterrotate. Rinse fluid could be supplied through the pad platen instead of or in conjunction with fluid supplied directly to the wafer surface. Other means of engaging, disengaging, and controlling the pressure applied by the pad may be used, including simple gravity-induced pressure. Rinse fluid viscosity may have an effect on required rotational velocity; fluids at temperatures other than room temperature or fluids with viscosities significantly different than that of DI water at a given temperature are comprehended by the present invention. In principle, other means of producing the accelerations taught herein for particle removal could be devised, which use a mechanism other than a spinning pad to remove particles.

## Claims

1. A method for removing particulate contaminants from a semiconductor wafer surface, said method comprising:
contacting said wafer surface with a cleaning pad;
supplying a rinse fluid to at least said wafer surface; and
rotating said cleaning pad at a rotational velocity sufficient to effect a centripetal acceleration of at least 24.4 m/sec² (80 ft/sec²) on at least one portion of said pad contacting said wafer surface.

2. The method of claim 1 further comprising performing said contacting, supplying and rotating steps after chemical-mechanical polishing of said wafer surface.

3. The method of claim 1 or claim 2 further comprising:
contacting a first portion of said wafer surface with a cleaning pad having an outer edge; and
supplying a rinse fluid to a second portion of said wafer surface.

4. The method of any of claims 1 to 3, further comprising rotating said wafer during said contacting step.

5. The method of any of claims 1 to 4, wherein said contacting step comprises holding said wafer surface and said cleaning pad together with an average pressure of at least 6.9 kPa (1 lb/in²).

6. The method of any of claims 1 to 5, further comprising performing said contacting step for a duration of less than 20 seconds.

7. The method of any preceding claim, wherein said supplying step comprises supplying a rinse fluid comprising deionized water.

8. The method of any preceding claim, wherein said rotating step comprises rotating the cleaning pad such that the magnitude of said centripetal acceleration exceeds 60.96 m/sec² (200 ft/sec²).

9. The method of any preceding claim, wherein said rotating step comprises rotating the cleaning pad such that the magnitude of said tangential velocity exceeds 2.1 m/sec (7 ft/sec).

10. The method of any preceding claim wherein said rinsing step comprises:
rinsing said wafer surface with deionized water; and
supplying deionized water to said wafer surface and/or said cleaning pad.

## Patentansprüche

1. Verfahren zum Entfernen teilchenförmiger Verunreinigungen von einer Halbleiterwafer-Oberfläche mit den folgenden Schritten:
In-Kontakt-Bringen der Waferoberfläche mit einer Reinigungsauflage,
Zuführen eines Spülfluids zumindest zu der Waferoberfläche und
Drehen der Reinigungsauflage mit einer Drehgeschwindigkeit, die ausreicht, um eine Zentripetalbeschleunigung von wenigstens 24,4 m/s² (80 ft/s²) an wenigstens einem Abschnitt der in Kontakt mit der Waferoberfläche stehenden Auflage zu bewirken.

2. Verfahren nach Anspruch 1, bei dem die Schritte des In-Kontakt-Bringens, des Zuführens und des Drehens weiter nach einem chemisch-mechanischen Polieren der Waferoberfläche ausgeführt werden.

3. Verfahren nach Anspruch 1 oder 2 mit den weiteren Schritten:
In-Kontakt-Bringen eines ersten Abschnitts der Waferoberfläche mit einer Reinigungsauflage, die einen Außenrand aufweist, und
Zuführen eines Spülfluids zu einem zweiten Abschnitt der Waferoberfläche.

4. Verfahren nach einem der Ansprüche 1 bis 3, bei dem der Wafer weiter während des Schritts des In-Kontakt-Bringens gedreht wird.

5. Verfahren nach einem der Ansprüche 1 bis 4, bei dem beim Schritt des In-Kontakt-Bringens die Waferoberfläche und die Reinigungsauflage mit einem durchschnittlichen Druck von wenigstens 6,9 kPa (1 lb/Zoll²) zusammengehalten werden.

6. Verfahren nach einem der Ansprüche 1 bis 5, bei dem der Schritt des In-Kontakt-Bringens weiter über eine Dauer von weniger als 20 Sekunden ausgeführt wird.

7. Verfahren nach einem der vorstehenden Ansprüche, bei dem beim Schritt des Zuführens ein deionisiertes Wasser enthaltendes Spülfluid zugeführt wird.

8. Verfahren nach einem der vorstehenden Ansprüche, bei dem beim Schritt des Drehens die Reinigungsauflage so gedreht wird, daß der Betrag der Zentripetalbeschleunigung 60,96 m/s² (200 ft/s²) übersteigt.

9. Verfahren nach einem der vorstehenden Ansprüche, bei dem beim Schritt des Drehens die Reinigungsauflage so gedreht wird, daß der Betrag der Tangentialgeschwindigkeit 2,1 m/s (7 ft/s) übersteigt.

10. Verfahren nach einem der vorstehenden Ansprüche, bei dem der Spülschritt die folgenden Schritte aufweist:
Spülen der Waferoberfläche mit deionisiertem Wasser und
Zuführen von deionisiertem Wasser zu der Waferoberfläche und/oder der Reinigungsauflage.

## Revendications

1. Dispositif pour enlever des substances polluantes particulaires d'une surface d'une pastille semiconductrice, ledit procédé consistant à:
placer ladite surface de la pastille en contact avec un tampon de nettoyage;
envoyer un fluide de rinçage sur au moins ladite surface de la pastille; et
faire tourner ledit tampon de nettoyage à une vitesse de rotation suffisante pour produire une accélération centripète d'au moins 24,4 m/s² (80 pieds/s²) dans au moins une partie dudit tampon en contact avec ladite surface de la pastille.

2. Procédé selon la revendication 1, comprenant en outre l'exécution desdites étapes de mise en contact, d'alimentation et de rotation après un polissage chimico-mécanique de ladite surface de la pastille.

3. Procédé selon la revendication 1 ou la revendication 2, comprenant en outre:
la mise en contact d'une première partie de ladite surface de la pastille avec un tampon de nettoyage possédant un bord extérieur, et
envoyer un fluide de rinçage à une seconde partie de ladite surface de la pastille.

4. Procédé selon l'une quelconque des revendications 1 à 3, consistant en outre à faire tourner ladite pastille pendant ladite étape de mise en contact.

5. Procédé selon l'une quelconque des revendications 1 à 4, selon lequel ladite étape de contact comprend le maintien de ladite surface de la pastille et dudit tampon de nettoyage conjointement avec une pression moyenne de 6,9 kPa (1 livre/pouce²).

6. Procédé selon l'une quelconque des revendications 1 à 5, comprenant en outre l'exécution de ladite étape de mise en contact pendant une durée inférieure à 20 secondes.

7. Procédé selon l'une quelconque des revendications précédentes, selon lequel ladite étape d'alimentation comprend l'envoi d'un fluide de rinçage comprenant de l'eau désionisée.

8. Procédé selon l'une quelconque des revendications précédentes, selon lequel ladite étape de rotation consiste à faire tourner le tampon de nettoyage de telle sorte que l'amplitude de ladite accélération centripète dépasse 60,96 m/s² (200 pieds/s²).

9. Procédé selon l'une quelconque des revendications précédentes, selon lequel ladite étape de rotation consiste à faire tourner le tampon de nettoyage de telle sorte que l'amplitude de ladite vitesse tangentielle dépasse 2,1 m/s (7 pieds/s).

10. Procédé selon l'une quelconque des revendications précédentes, selon lequel ladite étape de rinçage comprend:
le rinçage de ladite surface de la pastille avec de l'eau désionisée; et
l'envoi d'eau désionisée sur ladite surface de la pastille et/ou audit tampon de nettoyage.
